# EUROPEAN PATENT SPECIFICATION

(11) **EP 3 340 327 B1**
(45) Date of publication and mention of the grant of the patent: **20.04.2022**
(21) Application number: 16205386.2
(22) Date of filing: 20.12.2016
(51) Int. Cl.: H01L 41/187, H01L 41/316, H01L 41/319, C23C 14/08, C23C 14/28, C23C 14/02

(54) **METHOD FOR MANUFACTURING AN IMPROVED PIEZOELECTRIC MATERIAL**
VERFAHREN ZUR HERSTELLUNG EINES VERBESSERTEN PIEZOELEKTRISCHEN MATERIALS
PROCÉDÉ DE FABRICATION D'UN MATÉRIAU PIÉZOÉLECTRIQUE AMÉLIORÉ

(43) Date of publication of application: 27.06.2018
(73) Proprietor: Solmates B.V., 7521 PE Enschede (NL)
(72) Inventor: Duc Nguyen, Minh, 7511 KR Enschede (NL); Dekkers, Jan Matthijn, 7611 CB Aadorp (NL); Rijnders, Augustinus Josephus Helena Maria, 7132 CS Lichtenvoorde (NL)
(74) Representative: 't Jong, Bastiaan Jacob

(56) References cited:
- ADARSH RAJASHEKHAR ET AL: "In situ laser annealing during growth of Pb(Zr 0.52 Ti 0.48 )O 3 thin films", APPLIED PHYSICS LETTERS, vol. 103, no. 3, 15 July 2013 (2013-07-15) , page 032908, XP055375139, US ISSN: 0003-6951, DOI: 10.1063/1.4816157

## Description

The invention relates to a method for manufacturing an improved piezoelectric thin film material according to the preamble of claim 1.

Such a method is known from Adarsh Rajashenkhar et.al. "In situ laser annealing during growth of Pb (Zr0.52Ti0.48) O3 thin films"

It is known in the prior art to deposit a piezoelectric material on a substrate using pulsed laser deposition (PLD). In order to have a good functioning of the piezoelectric material, such that the material will exhibit an expansion when a voltage is applied over the material, the crystal structure must be uniform and aligned. This is obtained with PLD by using a low deposition rate of the target material onto the substrate. This allows for the crystal structure of the formed layer to be uniformly oriented and for the microstructure to be dense.

However, a low deposition rate will increase the time for the piezoelectric material to be manufactured. When the deposition rate is increased, the orientation of the crystal structure will become more erratic, the microstructure will become porous and the resulting piezoelectric material will perform less than a material manufactured using a low deposition rate.

Piezoelectric material manufactured with a low deposition rate will expand in one direction when a voltage is applied and will exhibit shrinkage in the direction perpendicular to the expansion direction. The expansion is coupled to the shrinkage and the total expansion will be restricted because the shrinkage is limited by the clamping of the dense layer to the substrate. The piezoelectric material manufactured with a high deposition rate will perform less, when a voltage is applied, however the shrinkage in the direction perpendicular to the expansion direction is not restricted The porous microstructure allows free movement of the material because it is less hindered by the clamping effect to the substrate. This effect that expansion occurs in one direction is not limited by the clamping effect, is for some applications of advantage, especially when only movement in a direction perpendicular to the plane of the substrate is desired. This ability is expressed in the d33 value of a piezoelectric material.

The document *"*In situ annealing during growth of Pb(Zr0.52Ti0.48)O3 thin films" by A. Rajashekhar et al. - APPLIED PHYSIC LETTERS 103 (2013), 032908_1-4 (XP55375139) discloses a process for depositing PZT wherein the deposition is done with a pulsed laser in two layers.

It is an object of the invention to provide a method for manufacturing an improved piezoelectric material, wherein the above mentioned disadvantages are reduced or even removed.

This object is achieved according to the invention with a method according to claim 1.

If first a layer of piezoelectric material is deposited with a low deposition rate and then a second layer of piezoelectric material is deposited with a higher deposition rate, it proves that the crystal structure of the second layer is less erratic and thus more oriented. This results in a better expansion of the material when a voltage is applied, while the shrinkage in a direction perpendicular thereto still is not hindered by the clamping to the substrate, than would be expected with a piezoelectric material deposited by a low depositing rate.

It is believed by the applicant, that the first layer of piezoelectric material functions as kind of a template, which helps the second layer, when being deposited, to obtain a more uniform orientation.

The target material is lead zirconate titanate.

In a preferred embodiment of the invention the first deposition rate value is less than 40 nm/min locally on the substrate.

The deposition rate according to this invention is to be understood as the instantaneous amount of material being deposited by the plasma plume. Because the deposition rate is typically defined as a thickness per time unit and not related to the area, the instantaneous deposition rate must be considered. If not the instantaneous deposition rate would be used, but an average, then moving the plasma plume over a large substrate surface would immediately result in a lower average deposition rate. Therefore, within the invention, one should consider the amount of deposit locally on the substrate, i.e. the instantaneous deposition rate.

In a further preferred embodiment of the invention the first value is 20 nm/min +/- 5 nm/min, preferably 17 nm/min, and wherein the second value is 85 nm/min +/- 7 nm/min, preferably 87 nm/min locally on the substrate.

With these preferred values for the depositing rate of the first and second layer, an improved piezoelectric material is obtained, which material has a d33 value of over 300, when measured using the double beam laser interferometer The d33 values for the deposited thin film are larger than the d33 value for the same material in bulk ceramics.

Piezoelectric thin layer materials according to the prior art do not exhibit such a high value for the d33 parameter, when measured according to this standardized measuring method.

In yet another preferred embodiment of the method according to the invention the pulse frequency is increased for depositing the second layer at the higher deposition rate.

By increasing the pulse frequency, the speed of movement of the plasma plume over the substrate does not need to be changed. The pulse frequency is easily manipulated and accordingly the deposition rate can easily be set to a different value.

Preferably, the substrate material is a silicon or glass material.

It is further preferred to arrange an electrode material layer, for example a platinum layer, on the substrate, before the first layer is deposited. With the electrode layer, the voltage can easily be applied over the thickness of the deposited layers. This allows for the manufactured piezoelectric material to be used as a small actuator for moving an object in a direction perpendicular to the plane of the substrate.

The invention does not relate to a piezoelectric material comprising:
- a silicon base layer;
- a first layer of piezo electric material arranged on the base layer, which first layer has a high density; and
- a second layer of piezo electric material arranged on the first layer, which second layer has a density lower, than the first layer,
wherein the high density first layer has a uniform smooth microstructure, when viewed with a scanning electron microscope, while the lower density second layer has a microstructure out of loosely connected columns, when viewed with a scanning electron microscope.

Although it would be preferred to define the piezoelectric material in the common quantity (g/cm3), but for deposited layers it is at the time of filing of this application not possible to reliably determine the density in the common quantity. Therefore, the density is defined as an observation using a scanning electron microscope.

In a very preferred embodiment of the piezoelectric material not according to the invention the d33 value is higher than 300, when measured using the double beam laser interferometer. With this standardized test it is possible to reliably determine whether the deposited layers exhibit the properties, which are to be obtained by the invention.

These and other features of the invention will be elucidated in conjunction with the following examples.

### Example 1

According to the invention a pulsed laser deposition device is provided. This PLD device has a pulsed UV laser with a maximum pulse frequency of 100 Hz. A silicon wafer is mounted as substrate in the device and a lead zirconate titanate target is provided as target.

Then with the PLD device a first layer is deposited on the silicon wafer by pulsing the laser at a frequency of 10Hz at the target, such that a plasma plume of lead zirconate titanate is generated. This plasma plume is deposited at a rate of 17 nm/min locally on the substrate. After the first layer reached a thickness of 50 nm, the depositing of the first layer is ended.

Then a second layer is deposited onto the formed first layer, by pulsing the laser at a frequency of 50 Hz at the target, generating a plasma plume with a local deposition rate of 87 nm/min. With this higher deposition rate a second layer is formed until the second layer reached a thickness of 2000 nm.

The manufactured improved piezoelectric material is then subjected to the double beam laser interferometer method in order to determine the d33 value. This d33 value is 305 pm/ V.

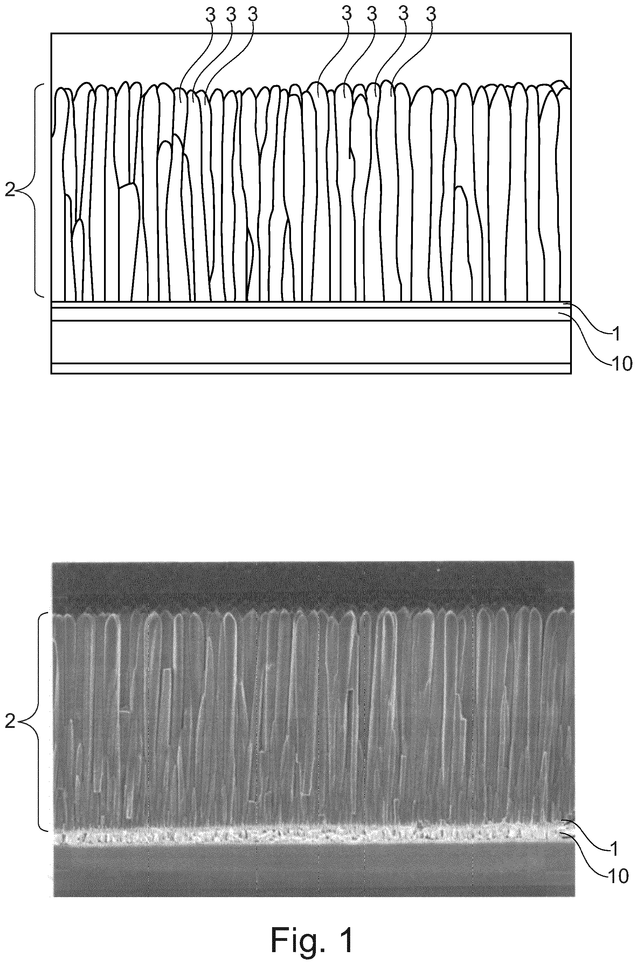

Figure 1 shows a picture of a scanning electron microscope with the stylized schematic representation thereof at the top, in which the first layer 1, which is deposited onto a platinum layer 10, has a uniform smooth microstructure.

The second layer 2 arranged on top of the first layer 1 has clearly a lower density, which is visible from the structure out of loosely connected columns 3. This structure is less erratic than when the second layer would be arranged without a first layer. This is shown in comparative example 3.

### Comparative example 2

In order to compare the d33 value of the example according to the invention, with the prior art, the same PLD device is provided with the same substrate and target.

For this comparative example only a first layer is deposited on the silicon wafer by pulsing the laser at a frequency of 10 Hz at the target to provide a local deposition rate of 17 nm/min until a layer thickness of 2000 nmis reached.

Then the manufactured comparative piezoelectric material is subjected to the same measurement method for determining the d33 value. This d33 value is 200 pm/Vfor this example.

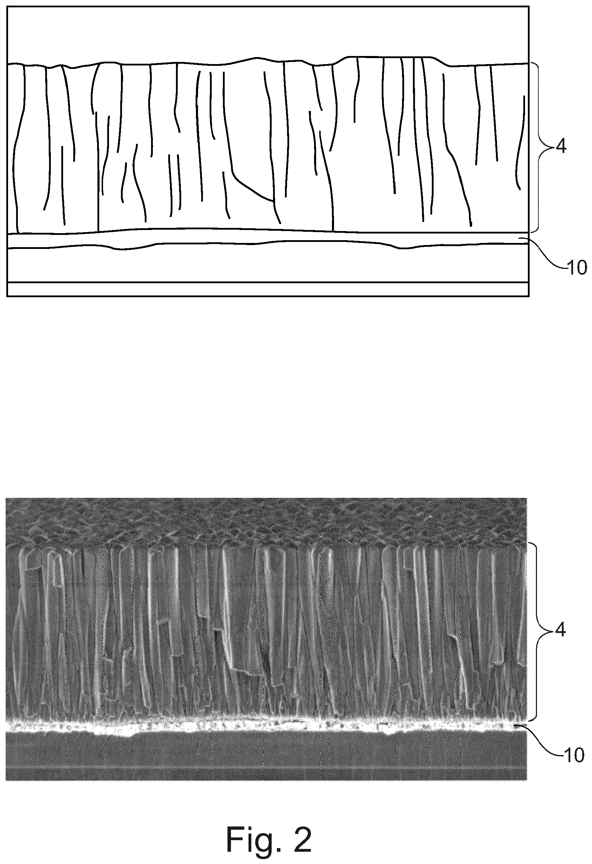

Figure 2 shows a picture of a scanning electron microscope with the stylized schematic representation thereof at the top, in which a single layer 4 is shown. The single layer 4 is deposited directly on a platinum layer 10. Due to the low depositing rate, the structure of this layer is more smooth.

### Comparative example 3

In order to compare the d33 value of the example according to the invention, with the prior art, the same PLD device is provided with the same substrate and target.

For this comparative example only a first layer is deposited on the silicon wafer by pulsing the laser at a frequency of 50 Hz at the target to provide a local depositing rate of 87 nm/min until a layer thickness of 2000 nm is reached.

Then the manufactured comparative piezoelectric material is subjected to the same measurement method for determining the d33 value. This d33 value is 236 pm/V for this example.

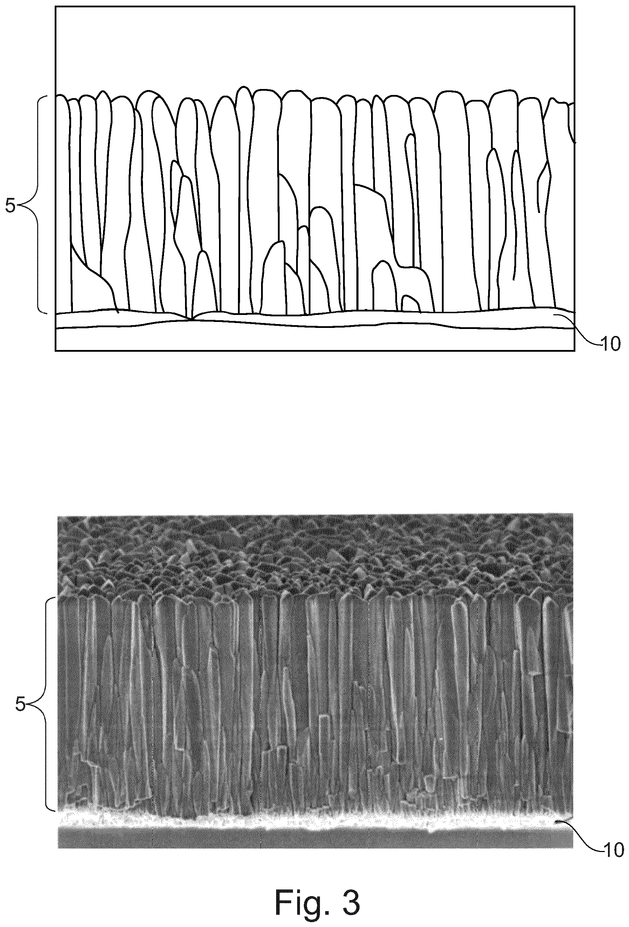

Figure 3 shows a picture of a scanning electron microscope with the stylized schematic representation thereof at the top, in which a single layer 5 is shown, which has due to the high depositing rate a more porous microstructure. This single layer 5 is arranged on a platinum layer 10.

As is clear from the example according to the invention and the two comparative examples, the two layered structure according to the invention provides an unexpected increase in the d33 value, which cannot be explained by the mere juxtaposition of the d33 values of the single layers as shown by the both comparative examples 2 and 3.

## Claims

1. Method for manufacturing a piezo electric thin film material comprising the steps of:
- providing a pulsed laser deposition device with a target and a substrate, wherein the target material is lead zirconate titanate;
- depositing a first layer of target material on the substrate by operating the pulsed laser deposition device, wherein the deposition rate is set to a first value;
- depositing a second layer of target material on top of the first layer by operating the pulsed laser deposition device,
**characterized in that** the deposition rate is set to a second value, wherein the second value is at least one and a half of the first value.

2. Method according to claim 1, wherein the first value is less than 40 nm/min.

3. Method according to claim 1 or 2, wherein the first value is 20 nm/min +/- 5 nm/min, preferably 17 nm/min, and wherein the second value is 85 nm/min +/- 7 nm/min, preferably 87 nm/min.

4. Method according to any of the preceding claims, wherein the pulse frequency is increased for depositing the second layer at the higher deposition rate.

5. Method according to any of the preceding claims, wherein the substrate material is a silicon or glass material.

6. Method according to claim 5, wherein an electrode material layer, for example a platinum layer, is arranged on the substrate, before the first layer is deposited.

## Patentansprüche

1. Verfahren zum Herstellen eines piezoelektrischen Dünnfilmmaterials, das die Schritte umfasst des:
- Bereitstellens einer Impulslaserabscheidungsvorrichtung mit einem Ziel und einem Substrat, wobei das Zielmaterial Bleizirkonattitanat ist;
- Abscheiden einer ersten Zielmaterialschicht auf dem Substrat durch Betätigen der Impulslaserabscheidungsvorrichtung, wobei die Abscheidungsrate auf einen ersten Wert eingestellt ist;
- Abscheiden einer zweiten Zielmaterialschicht auf der Oberseite der ersten Schicht durch Betätigen der Impulslaserabscheidungsvorrichtung,
**dadurch gekennzeichnet, dass** die Abscheidungsrate auf einen zweiten Wert eingestellt ist, wobei der zweite Wert mindestens anderthalb Mal der erste Wert ist.

2. Verfahren nach Anspruch 1, wobei der erste Wert kleiner ist als 40 nm/Min.

3. Verfahren nach Anspruch 1 oder 2, wobei der erste Wert 20 nm/Min. ± 5 nm/Min., bevorzugt 17 nm/Min. ist, und wobei der zweite Wert 85 nm/Min. ± 7 nm/Min., bevorzugt 87 nm/Min. ist.

4. Verfahren nach einem der vorstehenden Ansprüche, wobei die Impulsfrequenz zum Abscheiden der zweiten Schicht mit einer höheren Abscheidungsrate erhöht wird.

5. Verfahren nach einem der vorstehenden Ansprüche, wobei das Substratmaterial ein Silikon- oder Glasmaterial ist.

6. Verfahren nach Anspruch 5, wobei eine Elektrodenmaterialschicht, zum Beispiel eine Platinschicht, auf dem Substrat eingerichtet wird, bevor die erste Schicht abgeschieden wird.

## Revendications

1. Procédé pour fabriquer un matériau à film mince piézoélectrique comprenant les étapes consistant à :
- fournir un dispositif de dépôt laser pulsé avec une cible et un substrat, dans lequel le matériau cible est le titano-zirconate de plomb ;
- déposer une première couche de matériau cible sur le substrat en exploitant le dispositif de dépôt laser pulsé, dans lequel la vitesse de dépôt est fixée à une première valeur ;
- déposer une seconde couche de matériau cible par-dessus la première couche en exploitant le dispositif de dépôt laser pulsé,
**caractérisé en ce que** la vitesse de dépôt est fixée à une seconde valeur, dans lequel la seconde valeur représente au moins une fois et demie la première valeur.

2. Procédé selon la revendication 1, dans lequel la première valeur est inférieure à 40 nm/min.

3. Procédé selon la revendication 1 ou 2, dans lequel la première valeur est de 20 nm/min +/- 5 nm/min, de préférence 17 nm/min, et dans lequel la seconde valeur est de 85 nm/min +/- 7 nm/min, de préférence 87 nm/min.

4. Procédé selon l'une quelconque des revendications précédentes, dans lequel la fréquence d'impulsion est augmentée pour déposer la seconde couche à la seconde vitesse de dépôt.

5. Procédé selon l'une quelconque des revendications précédentes, dans lequel le matériau de substrat est un matériau au silicium ou en verre.

6. Procédé selon la revendication 5, dans lequel une couche de matériau d'électrode, par exemple une couche de platine, est agencée sur le substrat, avant que la première couche soit déposée.
